# EUROPEAN PATENT APPLICATION

(11) **EP 4 550 413 A1**
(43) Date of publication of application: **07.05.2025**
(21) Application number: 22955263.3
(22) Date of filing: 16.08.2022
(51) Int. Cl.: H01L 23/488

(54) **CHIP PACKAGE STRUCTURE, ELECTRONIC DEVICE, AND PACKAGING METHOD FOR CHIP PACKAGE STRUCTURE**

(71) Applicant: Huawei Technologies Co., Ltd., Shenzhen, Guangdong 518129 (CN)
(72) Inventor: DONG, Jinwen, Shenzhen, Guangdong 518129 (CN); ZHU, Jifeng, Shenzhen, Guangdong 518129 (CN)
(74) Representative: Maiwald GmbH
(86) International application number: PCT/CN2022/112780
(87) International publication number: WO 2024/036481

(57) **Abstract**

Embodiments of this application provide a chip package structure, an electronic device, and a packaging method of the chip package structure, and relate to the field of chip packaging technologies, to reduce impact of a TSV on performance of an electronic component. The chip package structure may include a first component chip, a support chip, and a second component chip. The second component chip is stacked on the support chip through a bonding layer, and the first component chip is disposed on a side that is of the second component chip and that is away from the support chip. A conductive channel penetrates the support chip and the second component chip. The support chip includes a first substrate, and the second component chip includes a second substrate and an electronic component layer formed on the second substrate. A thickness of the first substrate is greater than a thickness of the second substrate. A via diameter of a first conductive channel segment located in the first substrate is greater than a via diameter of a second conductive channel segment located in the second component chip. **In** this way, the conductive channel with a smaller via diameter penetrates the second component chip, to reduce impact on the electronic component.

## Description

### TECHNICAL FIELD

This application relates to the field of chip packaging technologies, and in particular, to a 3D stacked chip package structure, an electronic device, and a packaging method of the chip package structure.

### BACKGROUND

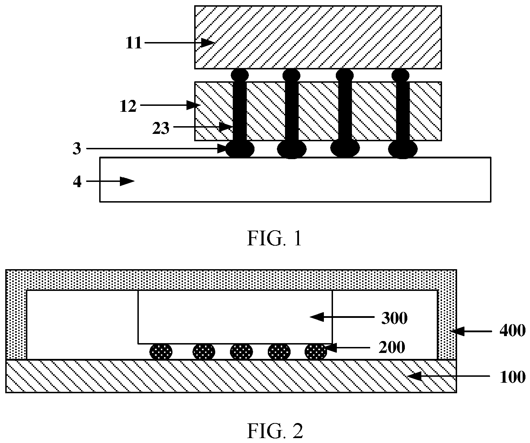

A surge in demand for computing power of high-speed data communication and artificial intelligence poses a challenge to chip integration density, and consequently many chip packaging forms emerge, for example, a three-dimensional (dimensional, 3D) stacked package structure. FIG. 1 is a diagram of a structure of a 3D stacked chip package structure including a component chip 11 and a component chip 12 that are stacked. The component chip 11 and the component chip 12 that are stacked are disposed on a package substrate 4 through solder joints 3. Compared with 2.5D stacking, 3D stacking may not only improve chip integration, but also reduce a signal delay, thereby increasing a computing speed.

However, in the 3D stacked package structure, as shown in FIG. 1, to interconnect the component chip 11 with another circuit on the package substrate 4, a through-silicon via (through-silicon via, TSV) 23 penetrating the component chip 12 is required. In some 3D stacked structures, the penetrating TSV 23 may generate a high stress, and the high stress may affect performance of an electronic component peripheral to the TSV. For example, when the electronic component is a field-effect transistor, the high stress generated by the TSV may damage a crystal lattice arrangement in the field-effect transistor, resulting in a drift of a startup current of the field-effect transistor. This limits application of the 3D stacked package structure.

### SUMMARY

Embodiments of this application provide a chip package structure, an electronic device including the chip package structure, and a packaging method of the chip package structure. The chip package structure is a 3D stacked package structure. The 3D stacked package structure may not only reduce impact of a TSV on performance of electronic components, but also increase integration density of the electronic components.

To achieve the foregoing objectives, the following technical solutions are used in embodiments of this application.

According to a first aspect, this application provides a chip package structure. The chip package structure may be a three-dimensional multi-chip stacked package.

The chip package structure may include a first component chip, a support chip, and a second component chip. The second component chip is stacked on the support chip through a bonding layer, and the first component chip is disposed on a side that is of the second component chip and that is away from the support chip. In other words, the first component chip and the second component chip implement 3D stacking. The chip package structure further includes a conductive channel. The conductive channel penetrates the support chip and the second component chip in a direction in which the support chip and the second component chip are stacked, and the conductive channel is electrically connected to the first component chip, so that the first component chip can be interconnected with a peripheral circuit through the conductive channel. The support chip includes a first substrate. The second component chip includes a second substrate and an electronic component layer formed on the second substrate. The electronic component layer is located on a side that is of the second substrate and that is away from the first substrate. In addition, a thickness of the first substrate is greater than a thickness of the second substrate. In the conductive channel, a via diameter of a first conductive channel segment located in the first substrate is greater than a via diameter of a second conductive channel segment located in the second component chip.

The chip package structure provided in this application includes the second component chip and the support chip that are bonded together. In addition, a via diameter of a conductive channel that penetrates the first substrate of the support chip is not equal to a via diameter of a conductive channel that penetrates the second component chip. In other words, the via diameter of the second conductive channel segment in the second component chip integrated with the electronic component layer is less than the via diameter of the first conductive channel segment in the support chip not integrated with the electronic component layer. In this way, in the second component chip, a stress generated by the second conductive channel segment with a smaller via diameter is low, and therefore an electronic component located at the periphery of the second conductive channel segment in the second component chip is basically not affected by the stress of the conductive channel with the smaller via diameter.

In addition, the via diameter of the second conductive channel segment that penetrates the second component chip is smaller. Therefore, on the basis of meeting a requirement for a size of a keep-out zone (Keep-Out Zone, KOZ) between the conductive channel and the peripheral electronic component, compared with a case in which the conductive channel with a larger via diameter, this can increase integration density of electronic components of the second component chip and improve performance of the 3D stacked package structure.

In addition, the thickness of the first substrate of the support chip having the conductive channel with a smaller via diameter is less than the thickness of the second substrate having the conductive channel with a larger via diameter. Therefore, in a process flow, basically no challenge is posed to the process, and the first conductive channel segment and the second conductive channel segment can be manufactured by using a filling technology with aspect ratios that are basically the same.

In a possible implementation, a ratio of a depth of the first conductive channel segment to the via diameter of the first conductive channel segment is greater than or equal to a ratio of a depth of the second conductive channel segment to the via diameter of the second conductive channel segment.

For example, each of the ratio of the depth of the first conductive channel segment to the via diameter of the first conductive channel segment and the ratio of the depth of the second conductive channel segment to the via diameter of the second conductive channel segment may be equal to 10: 1. In this way, the first conductive channel segment and the second conductive channel segment can be manufactured by using the same filling means.

In an implementable process, the ratio of the depth of the first conductive channel segment to the via diameter of the first conductive channel segment is less than the ratio of the depth of the second conductive channel segment to the via diameter of the second conductive channel segment.

In a possible implementation, the via diameter of the first conductive channel segment is D1, and D1>3 µm; and/or the via diameter of the second conductive channel segment is D2, and D2≤3 µm.

For example, 20 µm≥D1≥5 µm.

For example, 0.5 µm≤D2≤3 µm. For another example, 1 µm≤D2≤2 µm.

In a possible implementation, the thickness of the first substrate is H1, and H1≥30 µm; and/or the thickness of the second substrate is H2, and H2≤10 µm.

For example, 200 µm≥H1≥50 µm.

For example, 0.5 µm≤H2≤10 µm. For another example, 2 µm≤H2≤6 µm.

In a possible implementation, a step is formed for the conductive channel at the bonding layer.

In the process flow, the first conductive channel segment may be obtained in the first substrate by using a one-time hole drilling technology, and the second conductive channel segment may be obtained in the second component chip by using another one-time hole drilling technology, to form the step at the bonding layer.

In a possible implementation, the second component chip includes a first electronic component disposed at a periphery of the second conductive channel; in a first direction, a spacing between the first electronic component and the second conductive channel segment is S1, a spacing between the first electronic component and the first conductive channel segment is S2, and S1 is greater than S2; and the first direction is a direction parallel to the second substrate.

Because the via diameter of the second conductive channel segment that penetrates the second component chip is less than the via diameter of the first conductive channel segment that penetrates the first substrate, not only S1 can be greater than S2, but also more electronic components can be integrated into the electronic component layer.

In a possible implementation, each of the first conductive channel segment and the second conductive channel segment is a cone structure whose via diameter gradually decreases in a direction approaching the first component chip. A via diameter of an end that is of the second conductive channel segment and that is close to the first conductive channel segment is less than a via diameter of an end that is of the first conductive channel segment and that is close to the second conductive channel segment.

In a possible implementation, the chip package structure further includes a redistribution layer and a third component chip. The redistribution layer is formed on a side that is of the electronic component layer and that is away from the second substrate, and both the first component chip and the third component chip are disposed at the redistribution layer. The second conductive channel segment is electrically connected to the redistribution layer.

In this way, the first component chip and the third component chip may be interconnected through the redistribution layer. An interconnection between the first component chip or the third component chip and the peripheral circuit may be implemented by using the redistribution layer and the conductive channel.

In a possible implementation, the chip package structure further includes a package substrate. The package substrate is disposed on a side that is of the support chip and that is away from the second component chip, and the end of the first conductive channel segment is electrically connected to the package substrate.

For example, solder joints may be disposed on a side that is of the support chip and that is away from the second component chip, to implement electrical connection to the package substrate through the solder joints.

In a possible implementation, the second component chip is stacked on the support chip by using a direct bonding process.

The direct bonding process may also be referred to as a permanent bonding process.

According to a second aspect, this application provides a packaging method of a chip package structure. The packaging method includes:
stacking a component chip on a support chip through a bonding layer, where the support chip includes a first substrate, the component chip includes a second substrate and an electronic component layer formed on the second substrate, the electronic component layer is located on a side that is of the second substrate and that is away from the first substrate, a first conductive channel segment penetrates the first substrate, and a thickness of the first substrate is greater than a thickness of the second substrate; and
disposing a second conductive channel segment in the component chip, where the second conductive channel segment penetrates the electronic component layer and the second substrate and communicates with the first conductive channel segment, and a via diameter of the first conductive channel segment is greater than a via diameter of the second conductive channel segment.

In a chip package structure prepared according to the packaging method provided in this application, the via diameter of the second conductive channel segment that penetrates the component chip integrated with an electronic component is smaller. Correspondingly, a stress generated by a conductive channel with the smaller via diameter is low. Therefore, the stress basically does not affect the electronic component of the component chip.

In addition, because the via diameter of the conductive channel that penetrates the component chip is smaller, a keep-out zone KOZ between the electronic component and the conductive channel is also small. In this way, more electronic components can be integrated in a unit area to increase integration density of the electronic components.

In a possible implementation, the stacking a component chip on a support chip includes: bonding the component chip to the support chip through the bonding layer.

For example, a material like silicon carbide or silicon nitride may be used to bond the component chip and the support chip together.

In a possible implementation, when the second conductive channel segment is disposed in the component chip, a ratio of a depth of the second conductive channel segment to the via diameter of the second conductive channel segment is greater than or equal to a ratio of a depth of the first conductive channel segment to the via diameter of the first conductive channel segment.

For example, an aspect ratio of the first conductive channel segment may be 10: 1, and an aspect ratio of the second conductive channel segment is less than or equal to 10:1. For example, an aspect ratio of the second conductive channel segment is 8: 1 or 5: 1.

In a possible implementation, before the component chip is stacked on the support chip, the packaging method further includes: reducing the thickness of the second substrate of the component chip, so that the thickness of the second substrate is less than the thickness of the first substrate.

In other words, a conductive channel with a smaller via diameter penetrates a substrate with a smaller thickness, and a conductive channel with a larger via diameter penetrates a substrate with a larger thickness.

In a possible implementation, before the component chip is stacked on the support chip, the packaging method further includes: reducing the thickness of the second substrate of the component chip, so that the thickness of the second substrate is less than the thickness of the first substrate.

The component chip is disposed on a carrier to facilitate thinning of the second substrate of the component chip.

In a possible implementation, after the component chip is stacked on the support chip, the packaging method further includes: removing a side part that is of the first substrate and that is away from the component chip, so that the first conductive channel segment is exposed; and disposing a solder joint on the side that is of the first substrate and that is away from the component chip, so that the solder joint is electrically connected to the first conductive channel segment.

In an implementable structure, the solder joint may be connected to a package substrate, so that the three-dimensional stacked structure is integrated on the package substrate, and the component chip is electrically connected to a peripheral circuit on the package substrate.

In a possible implementation, the stacking a component chip on a support chip through a bonding layer includes: stacking the component chip on the support chip by using a direct bonding (direct bonding) process.

In a possible implementation, after the second conductive channel segment is disposed in the component chip, the packaging method further includes: forming a redistribution layer on the electronic component layer; and disposing at least two component chips at the redistribution layer.

In this way, the component chips disposed at the redistribution layer may be interconnected through the redistribution layer. In addition, the component chip at the redistribution layer may also be electrically connected to the peripheral circuit through the redistribution layer and the conductive channel (including the first conductive channel segment and the second conductive channel segment).

According to a third aspect, this application further provides an electronic device. The electronic device includes a printed circuit board and the chip package structure according to any one of the foregoing implementations, and the chip package structure is disposed on the printed circuit board and is electrically connected to the printed circuit board.

The electronic device provided in embodiments of this application includes the chip package structure according to any one of the foregoing implementations. Therefore, the electronic device provided in embodiments of this application and the chip package structure in the foregoing technical solutions can resolve a same technical problem, and achieve a same expected effect.

### BRIEF DESCRIPTION OF DRAWINGS

FIG. 1 is a diagram of a structure of a 3D stacked chip package structure;
FIG. 2 is a diagram of a structure of a partial structure of an electronic device according to an embodiment of this application;
FIG. 3 is a diagram of a structure of a chip package structure according to an embodiment of this application;
FIG. 4 is a diagram of a structure of a chip package structure according to an embodiment of this application;
FIG. 5 is a diagram of a structure of an interposer in a chip package structure according to an embodiment of this application;
FIG. 6 is a diagram of a structure of an interposer in a chip package structure according to an embodiment of this application;
FIG. 7a is an enlarged view of a part A in FIG. 6;
FIG. 7b is a diagram of a structure compared with that shown in FIG. 7a;
FIG. 8 is a diagram of a structure of a chip package structure according to an embodiment of this application;
FIG. 9 is a diagram of a structure of an interposer in a chip package structure according to an embodiment of this application;
FIG. 10 is a flowchart block diagram of a packaging method of a chip package structure according to an embodiment of this application; and
FIG. 11a to FIG. 11i are diagrams of corresponding structures obtained after steps in a method for preparing a chip package structure are completed according to an embodiment of this application.

Reference numerals:
100: PCB;
200: electrical connection structure;
300, 400: chip package structure;
500: heat sink;
11, 12, 13, 14: component chip;
2: interposer;
3: solder joint;
4: package substrate;
5: carrier;
21: redistribution layer;
22: component chip, namely, second component chip; 221: substrate, namely, second substrate; 222: electronic component layer; 222a: electronic component;
23: conductive channel, namely, TSV; 23a: first conductive channel segment; 23b: second conductive channel segment;
24: support chip; 241: substrate, namely, first substrate;
25: bonding layer;
26: conductive via;
27: step;
28: temporary-bonding layer.

### DESCRIPTION OF EMBODIMENTS

Embodiments of this application provide an electronic device. The electronic device may be a communication device, or may be another electronic device. For example, the electronic device may include a server (server), or may be a data center (data center), or may be another interconnection communication device. For another example, the electronic device may include a mobile phone (mobile phone), a tablet computer (a pad), a smart wearable product (for example, a smartwatch or a smart band), a virtual reality (virtual reality, VR) device, or an augmented reality (augmented reality, AR) device, or may be a device like a home appliance. A specific form of the electronic device is not specially limited in embodiments of this application.

As shown in FIG. 2, for example, different electronic devices may include a printed circuit board (printed circuit board, PCB) 100 and a chip package structure 300. The chip package structure 300 is electrically connected to the PCB 100 by using an electrical connection structure 200, so that the chip package structure 300 can implement a signal interconnection with another chip or another electronic module on the PCB 100.

In addition, still as shown in FIG. 2, the electronic device may further include a heat sink 500. The heat sink 500 covers the chip package structure 300 and the another electronic module on the PCB 100, and is fastened to the PCB 100. The heat sink 500 herein is used as a heat dissipation structure, and may perform heat dissipation and cooling on the chip package structure 300 and the another electronic module on the PCB 100. In addition, the heat sink 500 may also physically protect the chip package structure 300.

In an optional implementation, the electrical connection structure 200 may include a plurality of solder balls, for example, a ball grid array (ball grid array, BGA), or may include a plurality of metal pillars.

With development from fourth-generation mobile communication technologies (4th generation of wireless communication technologies, 4G) to fifth-generation mobile communication technologies (5th generation of wireless communication technologies, 5G) or even to next-generation communication technologies, integration density of a chip interconnection in the chip package structure 300 in FIG. 1 is increasingly high. For example, high-density chip integration may be implemented by using a 3D stacked package structure.

In some examples, the chip package structure 300 may be a processor, for example, may include a dynamic random-access memory (dynamic random-access memory, DRAM) and a system on a chip (system on a chip, SOC). For another example, the chip package structure 300 may include a system on a chip SoC and an analog chip, or may include an analog chip and another digital chip.

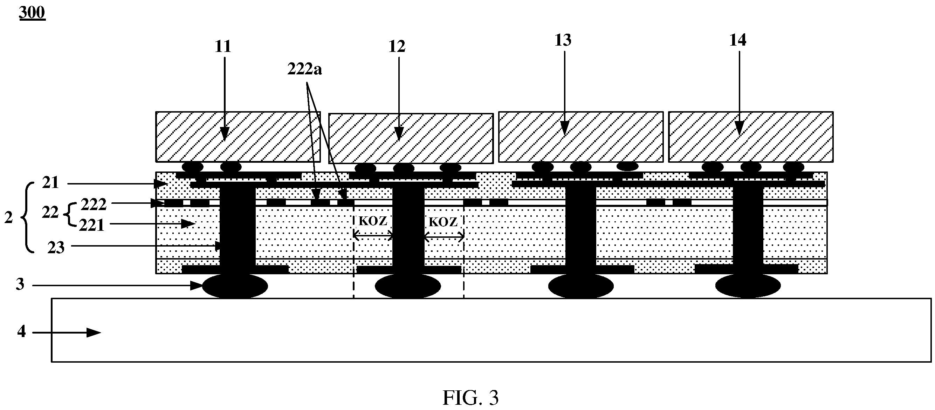

FIG. 3 is a diagram of a structure of a 3D stacked chip package structure 300. The chip package structure 300 is a silicon bridge across fanout package (silicon bridge across fanout package, SBAFOP) structure. The chip package structure 300 includes a plurality of component chips, for example, a component chip 11, a component chip 12, a component chip 13, and a component chip 14. These component chips are disposed at an interposer (Interposer) 2 through two-dimensional integration. In addition, the interposer 2 may be disposed on the package substrate 4 through solder joints 3.

The component chip 11, the component chip 12, the component chip 13, or the component chip 14 in FIG. 3 may be a functional chip. For example, some of these component chips are memories, and some of these component chips are controllers.

In embodiments of this application, as shown in FIG. 3, component chips (the component chip 11, the component chip 12, the component chip 13, and the component chip 14) integrated at the interposer 2 may be referred to as a first component chip.

Still as shown in FIG. 3, the interposer 2 includes a second component chip 22 and a redistribution layer (redistribution layer, RDL) 21 disposed on the second component chip 22. A signal interconnection between the component chip 11, the component chip 12, the component chip 13, and the component chip 14 may be implemented through the RDL 21. The second component chip 22 may also be interconnected with the component chip 11, the component chip 12, the component chip 13, or the component chip 14 through the RDL 21.

In addition, the second component chip 22 includes a substrate 221 and an electronic component layer 222 formed on the substrate 221. For example, the second component chip 22 may be an active chip (an active wafer). The interposer 2 formed based on this may be referred to as an active interposer (Active Interposer).

Still refer to FIG. 3, because at least one component chip in the component chip 11, the component chip 12, the component chip 13, and the component chip 14 is stacked with the second component chip 22 through three-dimensional integration, a packaging manner shown in FIG. 3 is 3D stacked packaging. This packaging manner may not only increase chip integration density, but also reduce a signal delay, increase an operation speed, and the like.

Still refer to FIG. 3. A conductive channel 23, for example, a through-silicon via (through-silicon via, TSV) 23, penetrates the second component chip 22, to implement an interconnection between a peripheral circuit and the component chip 11, the component chip 12, the component chip 13, and the component chip 14. In other words, one end of the TSV 23 is electrically connected to the RDL 21, and the other end of the TSV 23 is electrically connected to the solder joint 3. In this way, for example, the component chip 11 may perform signal intercommunication with another circuit on the package substrate 4 through the RDL 21 and the TSV 23.

In the chip package structure 300 shown in FIG. 3, a thickness of the substrate 221 is basically greater than or equal to 50 µm. For example, the thickness of the substrate 221 may be 100 µm, or the thickness of the substrate 221 may be 200 µm. Based on a capability of a semiconductor preparing device to fill the TSV 23, when a depth of the TSV 23 is large, a via diameter of the TSV 23 is also large. For example, the depth of the TSV is 50 µm and the diameter of the TSV is 5 µm. For another example, the depth of the TSV is 100 µm and the diameter of the TSV is 10 µm. In this way, when the via diameter of the TSV 23 is large, for example, when the via diameter is greater than or equal to 5 µm, the TSV 23 with the large via diameter generates a high stress, and the high stress affects performance of an electronic component 222a at the periphery of the TSV 23. For example, if the electronic component 222a is a field-effect transistor, the high stress may damage a lattice arrangement in the field-effect transistor. For example, the high stress may damage a crystal lattice arrangement of a substrate of the field-effect transistor, resulting in a drift of a startup current of the field-effect transistor, and consequently operating performance of the transistor is degraded.

To ensure the operating performance of the electronic component 222a, there is a strict requirement on a size of a keep-out zone (Keep-Out Zone, KOZ) between the TSV 23 and the electronic component 222a. For example, the size of the KOZ needs to be at least three times as large as the diameter of the TSV 23. For example, when the diameter of the TSV 23 is 10 µm, the KOZ is at least 30 µm.

In this way, although impact of the TSV 23 with the large via diameter on the performance of the electronic component 222a can be reduced, a quantity of electronic components 222a integrated on the second component chip 22 is reduced. This reduces integration of the electronic components and therefore limits application of the component interposer.

To increase integration density of the electronic components and reduce the impact of the TSV on the performance of the electronic components, an embodiment of this application provides a 3D stacked chip package structure. Details are as follows.

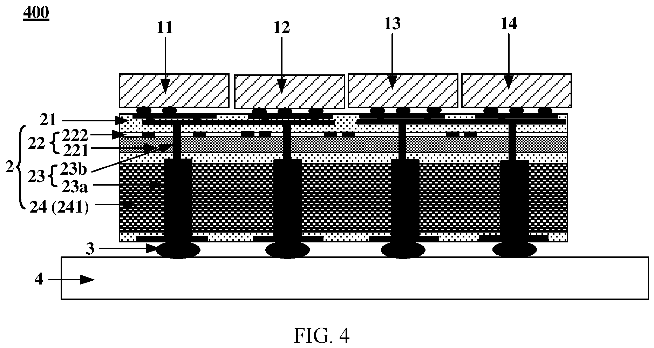

FIG. 4 is a diagram of a structure of a 3D stacked chip package structure 400 according to an embodiment of this application. A difference between the chip package structure 400 shown in FIG. 4 and the chip package structure 300 shown in FIG. 3 lies in that structures that can be implemented by the interposer 2 are different. The following describes the interposer 2 shown in FIG. 4 in detail.

As shown in FIG. 4, a component chip 11, a component chip 12, a component chip 13, and a component chip 14 are disposed at the interposer 2 through two-dimensional integration. In some implementable structures, a plurality of component chips may be further stacked on the component chip 11, the component chip 12, the component chip 13, or the component chip 14, to form a three-dimensional stacked structure.

In addition, the component chip 11, the component chip 12, the component chip 13, and the component chip 14 that are located at the interposer 2 may be wrapped by a molding package disposed at the interposer 2, to protect these component chips. In addition, the plastic package not only protects the component chips, but also shields the component chips from interference of external electromagnetic radiation.

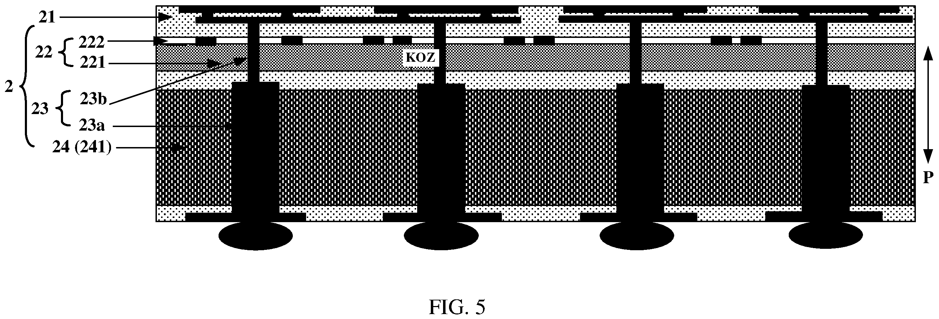

Refer to FIG. 4 and FIG. 5 again. FIG. 5 is a diagram of a structure of the interposer 2 in FIG. 4. With reference to FIG. 4 and FIG. 5, in this embodiment, the interposer 2 not only includes a second component chip 22 and a redistribution layer (redistribution layer, RDL) 21 that is disposed on the second component chip 22, but also includes a support chip (a carrier wafer) 24. The second component chip 22 is disposed on the support chip 24. The support chip 24 includes a substrate 241. The substrate 241 and a substrate 221 of the second component chip 22 are two independent substrates. To avoid confusion in subsequent description, the substrate 241 of the support chip 24 may be referred to as a first substrate, and the substrate 221 included in the second component chip 22 may be referred to as a second substrate 221.

In some examples, the second component chip 22 is supported on the first substrate 241. It may be understood that the support chip (the carrier wafer) is a chip on which no electronic component is disposed.

In some application scenarios provided in embodiments of this application, for example, as shown in FIG. 4, the second component chip 22 may be a controller. The component chip 11 (which may also be referred to as a first component chip) may be a memory, and the second component chip 22 may control a read/write operation on the memory chip. For another example, the second component chip 22 may be a system on a chip (system on a chip, SoC), and the component chip 11, the component chip 12, the component chip 13, or the component chip 14 may be a power management chip, a memory, or another functional chip.

In addition, the chip in this application may be a wafer (wafer), or may be a die (die) cut from a wafer.

As shown in FIG. 5, the second substrate 221 of the second component chip 22 is disposed close to the first substrate 241, and an electronic component layer 222 of the second component chip 22 is located on a side that is of the second substrate 221 and that is away from the first substrate 241. In addition, the RDL 21 is formed on the electronic component layer 222.

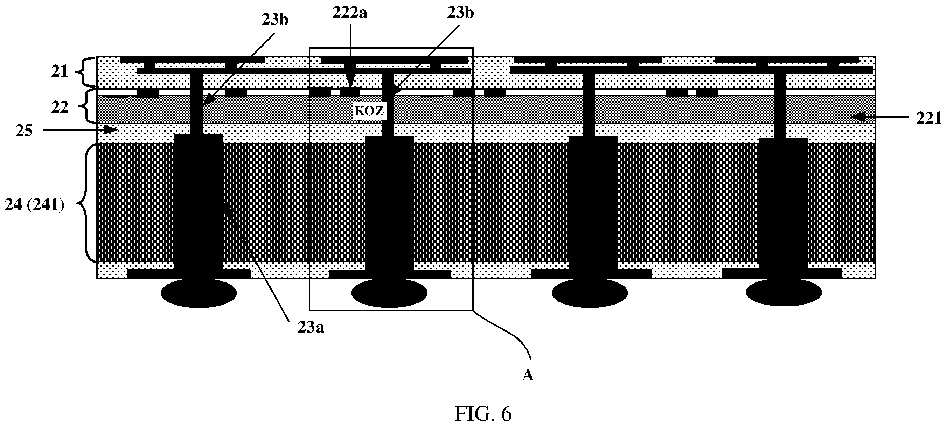

FIG. 6 shows a connection relationship existing when the support chip 24 and the second component chip 22 are stacked. In an implementable structure, the support chip 24 is connected to the second substrate 221 of the second component chip 22 through a bonding layer 25. In other words, the second component chip and the support chip are stacked through the bonding layer.

For example, a material that may be selected for the bonding layer 25 is one or more of SiO₂ (silicon dioxide), Al₂O₃ (aluminum oxide), HfO₂ (hafnium dioxide), ZrO₂ (zirconium dioxide), TiO₂ (titanium dioxide), Y₂O₃ (yttrium oxide), and Si₃N₄ (silicon nitride).

As shown in FIG. 4 and FIG. 5, in a direction in which the support chip stacks with the second component chip, a conductive channel 23 is further formed in the interposer 2, to implement an interconnection between the chip integrated at the interposer 2 and a peripheral circuit. The conductive channel 23 penetrates the second component chip 22, the bonding layer 25, and the first substrate 241. In addition, one end of the conductive channel 23 is electrically connected to the RDL 21, and the other end of the conductive channel 23 is electrically connected to a solder joint 3. In this way, the component chip (for example, the component chip 11) integrated at the interposer 2 may be vertically interconnected with the peripheral circuit through the RDL 21 and the conductive channel 23.

Still refer to FIG. 6. The conductive channel 23 includes a first conductive channel segment 23a that penetrates the first substrate 241 and a second conductive channel segment 23b that penetrates the second substrate 221 and the electronic component layer 222 in the second component chip 22. A via diameter of the first conductive channel segment 23a is greater than a via diameter of the second conductive channel segment 23b.

It can be learned from the foregoing description that the second conductive channel segment 23b with a smaller via diameter is electrically connected to the RDL 21 through the electronic component layer 222 of the second component chip 22. In other words, a conductive channel that penetrates the electronic component layer 222 has a smaller via diameter than the first conductive channel segment 23a that penetrates the first substrate 241 on which no electronic component is disposed. In this way, a stress generated by the second conductive channel segment 23b with the smaller via diameter is low, and the electronic component 222a is basically not affected by the stress generated by the second conductive channel segment 23b with the smaller via diameter. This can ensure operating performance of the second component chip 22.

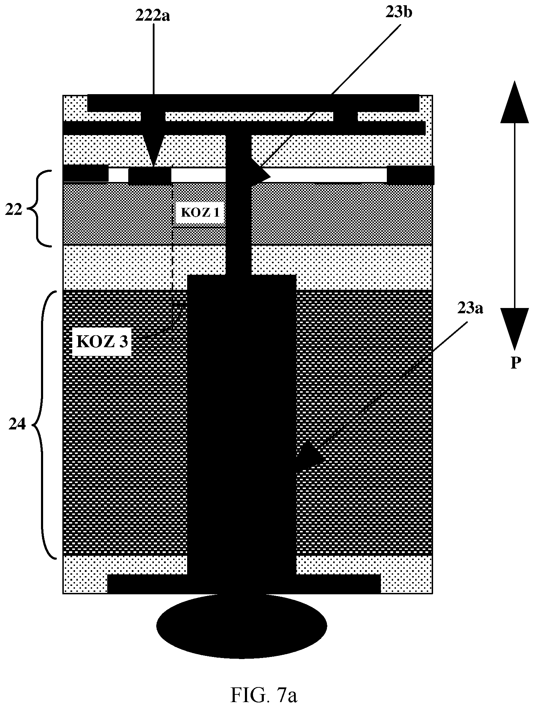

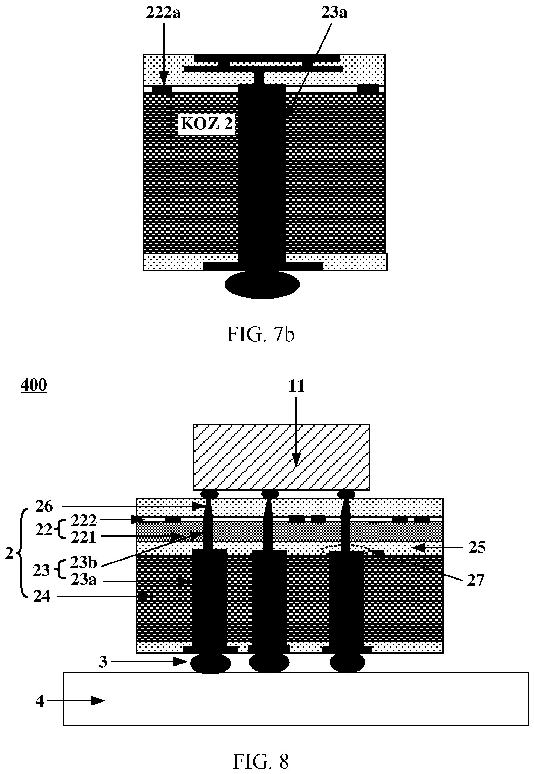

Refer to FIG. 7a and FIG. 7b. FIG. 7a is an enlarged view of a part A in FIG. 6, and FIG. 7b is a diagram of a structure used for comparison with the structure shown in FIG. 7a according to an embodiment of this application. FIG. 7a shows the second conductive channel segment 23b having the smaller via diameter at the periphery of the electronic component 222a, and a keep-out zone (Keep-Out Zone, KOZ) between the electronic component 222a and the second conductive channel segment 23b is a KOZ 1. FIG. 7b shows the first conductive channel segment 23a having a larger via diameter at the periphery of the electronic component 222a, and a keep-out zone (Keep-Out Zone, KOZ) between the electronic component 222a and the first conductive channel segment 23a is a KOZ 2.

To ensure operating performance of the electronic component 222a in FIG. 7a and FIG. 7b, for example, when the via diameter of the second conductive channel segment 23b in FIG. 7a is 3 µm, the KOZ 1 is at least 9 µm. However, in FIG. 7b, when the via diameter of the first conductive channel segment 23a is 8 µm, the KOZ 2 is at least 24 µm. It is clear that the KOZ 2 is far greater than the KOZ 1. In this way, compared with those in FIG. 7b, more electronic components 222a may be integrated in a unit area in FIG. 7a, to increase integration density of the electronic components and improve performance of the second component chip 22. For example, when the second component chip 22 is a memory, more storage units may be integrated in a unit area to increase storage density, thereby increasing a storage capacity.

This may be understood as follows: When the conductive channel structure shown in FIG. 7a provided in this embodiment of this application is used, in a direction perpendicular to the direction in which the support chip 24 stacks with the second component chip 22 (a direction P in FIG. 7a), a spacing between the electronic component 222a and the second conductive channel segment 23b is the KOZ 1, and a spacing between the electronic component 222a and the first conductive channel segment 23a is a KOZ 3. The KOZ 1 is greater than the KOZ 3.

Refer to FIG. 5, a thickness of the second substrate 221 of the second component chip 22 is less than a thickness of the first substrate 241. The thickness is a size of the second component chip 22 or the first substrate 241 in the stacking direction P.

In other words, in this embodiment of this application, the thickness of the second substrate 221 is less than the thickness of the first substrate 241, and the via diameter of the first conductive channel segment 23a formed in the first substrate 241 is greater than the via diameter of the second conductive channel segment 23b formed in the second substrate 221. For example, a ratio of a depth of the first conductive channel segment 23a to the via diameter of the first conductive channel segment 23a (aspect ratio, aspect ratio) may be basically the same as a ratio of a depth of the second conductive channel segment 23b to the via diameter of the second conductive channel segment 23b. In this way, a hole filling process of the first conductive channel segment 23a may be compatible with a hole filling process of the second conductive channel segment 23b. In other words, the first conductive channel segment 23a and the second conductive channel segment 23b may be manufactured by using a same hole filling process, so that no challenge is posed to a manufacturing process.

In some implementable structures, the via diameter of the first conductive channel segment 23a is D1, and a value range of D1 may be D1>3 µm or 20 µm≥D1>3 µm. For example, D1=5 µm. For another example, D1=10 µm. For still another example, D1=20 µm.

In some other implementable structures, the via diameter of the second conductive channel segment 23b is D2, and a value range of D2 may be D2≤3 µm or 3 µm≥D2≥0.5 µm. For example, D2=3 µm. For another example, D2=2 µm. For still another example, D2=1 µm.

In addition, in some structures, the thickness of the first substrate 241 is H1, and a value range of H1 may be H1≥30 µm or 200 µm≥H1≥30 µm. For example, H1=50 µm. For another example, H1=100 µm. For still another example, H1=200 µm.

In another structure, the thickness of the second substrate 221 is H2, and a value range of H2 may be H2≤10 µm or 10 µm≥H2≥0.5 µm. For example, H2=10 µm. For another example, H2=5 µm. For still another example, H2=2 µm.

For example, in the structure shown in FIG. 6, the via diameter D1 of the first conductive channel segment 23a is 5 µm, and the thickness H1 of the first substrate 241 is 50 µm. The via diameter D2 of the second conductive channel segment 23b is 3 µm, and the thickness H2 of the second substrate 221 is 10 µm.

In some implementable structures, the aspect ratio of the first conductive channel segment 23a may be greater than or equal to the aspect ratio of the second conductive channel segment 23b. For example, the aspect ratio of the first conductive channel segment 23a and the aspect ratio of the second conductive channel segment 23b each are 10:1. Alternatively, the aspect ratio of the first conductive channel segment 23a is 10:1, and the aspect ratio of the second conductive channel segment 23b is 5:1.

In some other implementable structures, the aspect ratio of the first conductive channel segment 23a may alternatively be less than the aspect ratio of the second conductive channel segment 23b. For example, the aspect ratio of the first conductive channel segment 23a is 8:1, and the aspect ratio of the second conductive channel segment 23b is 10:1.

FIG. 8 is a diagram of a structure of another 3D stacked chip package structure 400 according to an embodiment of this application. Different from the embodiment shown in FIG. 4, in the example shown in FIG. 8, an interconnection structure used for electrically connecting the component chip 11 and the second component chip 22 in the interposer 2 is a conductive via 26 that penetrates the interposer layer. For example, the conductive via 26 may be a through-silicon via TSV. In contrast, in FIG. 4, the interconnection between the component chip 11 and the second component chip 22 is implemented by using the RDL 21. Other structures of the embodiment shown in FIG. 8 are the same as those in the example shown in FIG. 4, and same features and effects are not explained herein again.

Regardless of the embodiment shown in FIG. 4 or the embodiment shown in FIG. 8, a step 27 is formed for the conductive channel 23 at the bonding layer 25 between the first substrate 241 and the second substrate 221. In other words, as shown in FIG. 8, the via diameter of the second conductive channel segment 23b located above the step 27 is less than the via diameter of the first conductive channel segment 23a located below the step 27.

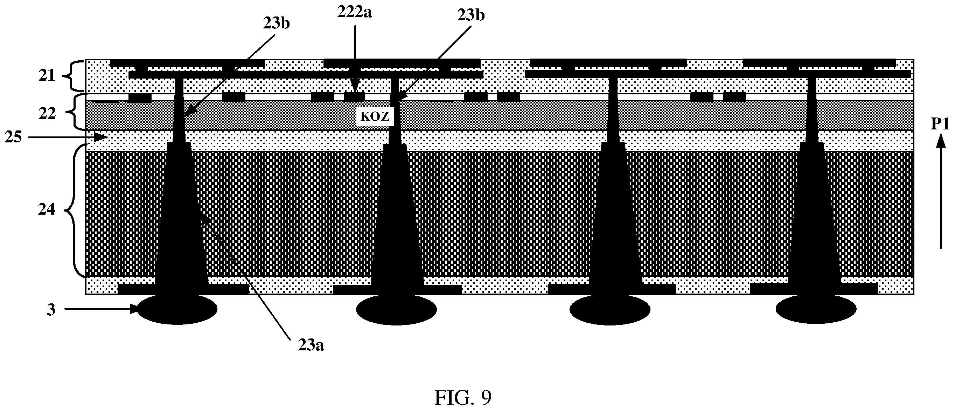

In some implementable structures, a shape of the first conductive channel segment 23a may be a cone structure. As shown in FIG. 9, in a direction approaching the component chip 11 (a direction P1 shown in FIG. 9), the via diameter of the first conductive channel segment 23a gradually decreases.

In some implementable structures, a shape of the second conductive channel segment 23b may also be a cone structure. As shown in FIG. 9, in the direction approaching the component chip 11 (the direction P1 shown in FIG. 9), the via diameter of the second conductive channel segment 23b also gradually decreases. In addition, a via diameter of an end that is of the second conductive channel segment 23b and that is close to the first conductive channel segment 23a is less than a via diameter of an end that is of the first conductive channel segment 23a and that is close to the second conductive channel segment 23b. In this way, the step 27 is formed at the bonding layer 25.

When each of the first conductive channel segment 23a and the second conductive channel segment 23b shown in FIG. 9 is the cone structure, the via diameter in the aspect ratio of the first conductive channel segment 23a may be understood as a via diameter of an end that is of the first conductive channel segment 23a and that is close to the solder joint 3, and the via diameter in the aspect ratio of the second conductive channel segment 23b may be understood as a via diameter that is of the first conductive channel segment 23a and that is close to the RDL 21.

In some other implementable structures, because the thickness of the second substrate 221 is smaller, the shape of the second conductive channel segment 23b formed in the second substrate 221 may alternatively be a cylindrical structure.

The first conductive channel segment 23a or the second conductive channel segment 23b may be understood as a conductive channel formed by drilling a hole in the substrate and then filling the hole with a conductive material. For example, a diffusion barrier is first formed on a wall surface of the hole, and then a conductive layer is formed on the diffusion barrier, so that the conductive layer fills the remaining space of the hole. The diffusion barrier in this example may suppress conductive particles in the conductive layer from diffusing into the substrate.

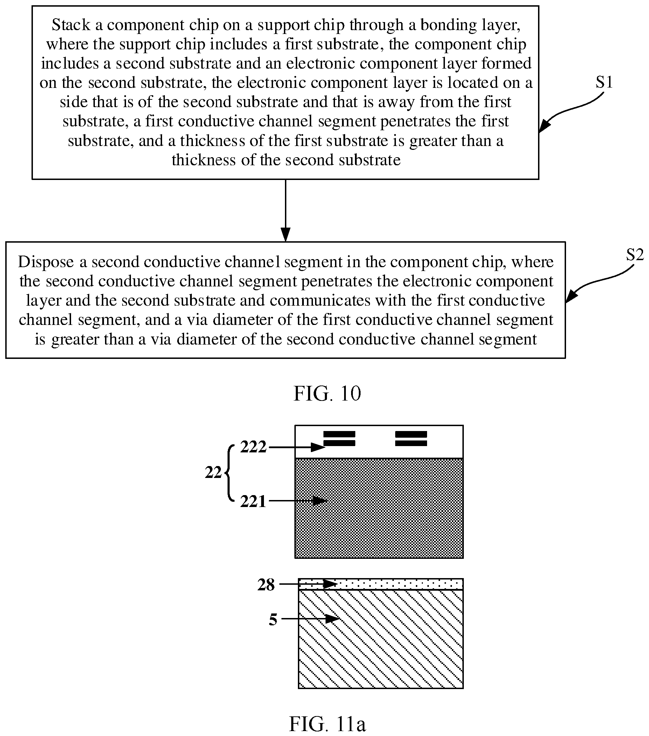

Embodiments of this application further provides a packaging method of a chip package structure. FIG. 10 is a flowchart block diagram of the packaging method according to an embodiment of this application. As shown in FIG. 10, the packaging method includes the following steps.

S1: Stack a component chip on a support chip through a bonding layer, where the support chip includes a first substrate, the component chip includes a second substrate and an electronic component layer formed on the second substrate, the electronic component layer is located on a side that is of the second substrate and that is away from the first substrate, a first conductive channel segment penetrates the first substrate, and a thickness of the first substrate is greater than a thickness of the second substrate.

In other words, before the support chip and the component chip are stacked, the first conductive channel segment may be first formed in the first substrate of the support chip.

S2: Dispose a second conductive channel segment in the component chip, where the second conductive channel segment penetrates the electronic component layer and the second substrate and communicates with the first conductive channel segment, and a via diameter of the first conductive channel segment is greater than a via diameter of the second conductive channel segment.

FIG. 11a to FIG. 11i are diagrams of structures that may be implemented after a process flow shown in FIG. 10 is refined and the steps are performed. With reference to FIG. 11a to FIG. 11i, the packaging method is as follows.

As shown in FIG. 11a, a component chip 22 and a carrier 5 are prepared.

The component chip 22 includes a substrate 221 and an electronic component layer 222 formed on the substrate 221.

The carrier 5 provided in this embodiment of this application may be a glass package substrate, a sapphire package substrate, a wafer, or the like.

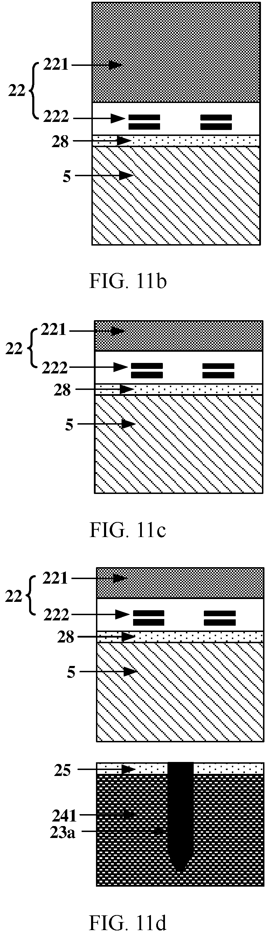

As shown in FIG. 11b, the component chip 22 and the carrier 5 provided in FIG. 11a are connected together.

For example, the component chip 22 may be stacked on the carrier 5 through a temporary-bonding layer 28. In addition, the electronic component layer 222 of the component chip 22 faces the carrier 5, and the substrate 221 is located on a side that is of the electronic component layer 222 and that is away from the carrier 5.

During aligned bonding (direct bonding), alignment may be implemented by using a bonding alignment (bonding alignment) process.

The bonding layer may be a laser debonding layer (a laser release layer) or the like.

As shown in FIG. 11c, the substrate 221 of the component chip 22 stacked on the carrier 5 shown in FIG. 11b is thinned.

In some implementable processes, a thickness of the substrate 221 may be reduced to 0.50 µm to 10 µm. For example, the thickness of the substrate 221 is 2 µm to 6 µm. For example, the thickness of the substrate 221 is selected to be 5 µm.

To be specific, it may be understood that the carrier 5 is used to facilitate thinning of the substrate 221 of the component chip 22.

As shown in FIG. 11d, a support chip is prepared. A first conductive channel segment 23a is disposed in a substrate 241 of the support chip in a thickness direction of the support chip. For example, if the substrate 241 is made of silicon, the first conductive channel segment 23a is a TSV structure.

For example, a thickness of the substrate 241 may be at least 250 µm. For example, a substrate 241 with a thickness of 300 µm may be selected.

In addition, the first conductive channel segment 23a formed in the substrate 241 does not penetrate two opposite surfaces of the substrate 241.

In an implementable process, a hole may be first drilled in the substrate 241, and then a conductive material like metal copper is filled in the hole, to obtain the conductive channel.

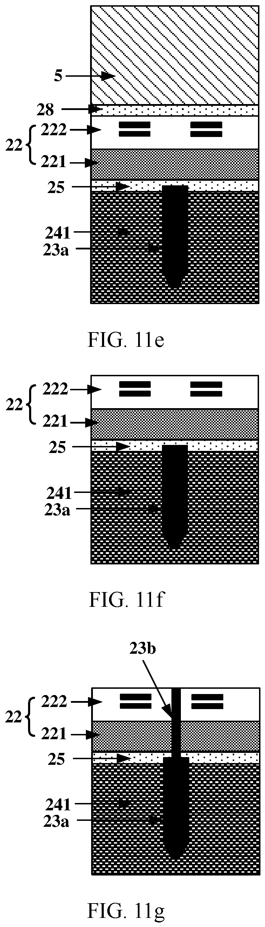

As shown in FIG. 11e, the substrate 241 having the first conductive channel segment 23a is connected to the substrate 221 of the component chip 22.

For example, the substrate 221 and the substrate 241 may be bonded through a bonding layer 25.

In a bonding process, direct bonding (direct bonding) which may also be referred to as aligned bonding (direct bonding) or permanent bonding may be used. Similarly, alignment may be implemented by using the bonding alignment (bonding alignment) process.

As shown in FIG. 11f, the carrier 5 is removed through debonding. The component chip 22 and the support chip that are stacked are remained.

As shown in FIG. 11g, a hole is drilled from the electronic component layer 222 of the component chip 22 to the substrate 221, the hole is communicated with the first conductive channel segment 23a, and then the hole is filled with the conductive material to form a second conductive channel segment 23b.

In some structures, a via diameter of the second conductive channel segment 23b is less than a via diameter of the first conductive channel segment 23a. For example, the via diameter of the second conductive channel segment 23b is 3 µm, and the via diameter of the first conductive channel segment 23a is 5 µm.

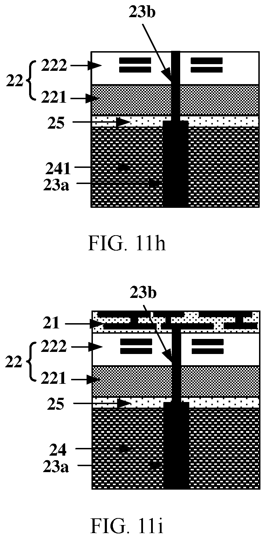

As shown in FIG. 11h, after the first conductive channel segment 23a and the second conductive channel segment 23b are formed, as shown in FIG. 11h, a part that is of the substrate 241 and that is away from the component chip 22 may be removed, so that the first conductive channel segment 23a is exposed. In this way, a solder joint (controlled collapse chip connection, C4) may be disposed on a side that is of the substrate 241 and that is away from the component chip 22.

Certainly, the packaging method may further include: forming an RDL 21 on the electronic component layer 222 of the component chip 22, and then disposing a plurality of component chips on the RDL 21, as shown in FIG. 11i.

In a chip package structure prepared according to the described packaging method, as shown in FIG. 11h, a via diameter of a conductive channel that penetrates the 3D stacked component chip 22 is smaller, and the conductive channel with the small via diameter generates a low stress. In this case, the low stress does not cause a greater impact on performance of a peripheral electronic component. This can ensure performance of the component chip 22 and reduce impact of the conductive channel on the electronic component, thereby expanding application of the 3D stacked chip package structure.

In addition, the thickness of the substrate 221 of the component chip 22 with the small via diameter is less than the thickness of the substrate 241 of the support chip that does not carry the component. In other words, the conductive channel with the smaller via diameter is disposed in the thinner substrate, and a conductive channel with a larger via diameter is disposed in the thicker substrate. In this way, two different conductive channels with substantially same aspect ratios may be manufactured by using compatible processes, so that no great challenge is posed to the processes.

In the descriptions of this specification, the described specific features, structures, materials, or characteristics may be combined 24in a proper manner in any one or more of embodiments or examples.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chip package structure, comprising:
a first component chip;
a support chip and a second component chip, wherein the second component chip is stacked on the support chip through a bonding layer, and the first component chip is disposed on a side that is of the second component chip and that is away from the support chip; and
a conductive channel, wherein the conductive channel penetrates the support chip and the second component chip in a direction in which the support chip and the second component chip are stacked, and the conductive channel is electrically connected to the first component chip;
the support chip comprises a first substrate, the second component chip comprises a second substrate and an electronic component layer formed on the second substrate, and the electronic component layer is located on a side that is of the second substrate and that is away from the first substrate;
a thickness of the first substrate is greater than a thickness of the second substrate; and
in the conductive channel, a via diameter of a first conductive channel segment located in the first substrate is greater than a via diameter of a second conductive channel segment located in the second component chip.

2. The chip package structure according to claim 1, wherein a ratio of a depth of the first conductive channel segment to the via diameter of the first conductive channel segment is greater than or equal to a ratio of a depth of the second conductive channel segment to the via diameter of the second conductive channel segment.

3. The chip package structure according to claim 1 or 2, wherein
the via diameter of the first conductive channel segment is D1, and D1>3 µm; and/or
the via diameter of the second conductive channel segment is D2, and D2≤3 µm.

4. The chip package structure according to any one of claims 1 to 3, wherein
the thickness of the first substrate is H1, and H1≥30 µm;
and/or
the thickness of the second substrate is H2, and H2≤10 µm.

5. The chip package structure according to any one of claims 1 to 4, wherein a step is formed for the conductive channel at the bonding layer.

6. The chip package structure according to any one of claims 1 to 5, wherein the second component chip comprises a first electronic component disposed at a periphery of the second conductive channel segment;
in a first direction, a spacing between the first electronic component and the second conductive channel segment is S1, a spacing between the first electronic component and the first conductive channel segment is S2, and S1 is greater than S2; and
the first direction is a direction parallel to the second substrate.

7. The chip package structure according to any one of claims 1 to 6, wherein
each of the first conductive channel segment and the second conductive channel segment is a cone structure whose via diameter gradually decreases in a direction approaching the first component chip; and
a via diameter of an end that is of the second conductive channel segment and that is close to the first conductive channel segment is less than a via diameter of an end that is of the first conductive channel segment and that is close to the second conductive channel segment.

8. The chip package structure according to any one of claims 1 to 7, wherein the second component chip is stacked on the support chip by using a direct bonding process.

9. The chip package structure according to any one of claims 1 to 8, wherein the chip package structure further comprises:
a redistribution layer; and
a third component chip;
the redistribution layer is formed on a side that is of the electronic component layer and that is away from the second substrate, and both the first component chip and the third component chip are disposed at the redistribution layer; and
the second conductive channel segment is electrically connected to the redistribution layer.

10. The chip package structure according to any one of claims 1 to 9, wherein the chip package structure further comprises a package substrate; and
the package substrate is disposed on a side that is of the support chip and that is away from the second component chip, and the end of the first conductive channel segment is electrically connected to the package substrate.

11. A packaging method of a chip package structure, comprising:
stacking a component chip on a support chip through a bonding layer, wherein the support chip comprises a first substrate, the component chip comprises a second substrate and an electronic component layer formed on the second substrate, the electronic component layer is located on a side that is of the second substrate and that is away from the first substrate, a first conductive channel segment penetrates the first substrate, and a thickness of the first substrate is greater than a thickness of the second substrate; and
disposing a second conductive channel segment in the component chip, wherein the second conductive channel segment penetrates the electronic component layer and the second substrate and communicates with the first conductive channel segment, and a via diameter of the first conductive channel segment is greater than a via diameter of the second conductive channel segment.

12. The packaging method of a chip package structure according to claim 11, wherein when the second conductive channel segment is disposed in the component chip, a ratio of a depth of the second conductive channel segment to the via diameter of the second conductive channel segment is greater than or equal to a ratio of a depth of the first conductive channel segment to the via diameter of the first conductive channel segment.

13. The packaging method of a chip package structure according to claim 11 or 12, wherein before the component chip is stacked on the support chip, the packaging method further comprises:
reducing the thickness of the second substrate of the component chip, so that the thickness of the second substrate is less than the thickness of the first substrate.

14. The packaging method of a chip package structure according to claim 13, wherein before the thickness of the second substrate of the component chip is reduced, the packaging method further comprises:
disposing the component chip on a carrier, so that the electronic component layer of the component chip faces the carrier, to thin the second substrate away from the carrier.

15. The packaging method of a chip package structure according to any one of claims 11 to 14, wherein the stacking a component chip on a support chip through a bonding layer comprises:
stacking the component chip on the support chip by using a direct bonding process.

16. The packaging method of a chip package structure according to any one of claims 11 to 15, wherein after the component chip is stacked on the support chip, the packaging method further comprises:
removing a side part that is of the first substrate and that is away from the component chip, so that the first conductive channel segment is exposed; and
disposing a solder joint on the side that is of the first substrate and that is away from the component chip, so that the solder joint is electrically connected to the first conductive channel segment.

17. The packaging method of a chip package structure according to any one of claims 11 to 16, wherein after the second conductive channel segment is disposed in the component chip, the packaging method further comprises:
forming a redistribution layer on the electronic component layer; and
disposing at least two component chips at the redistribution layer.

18. An electronic device, comprising:
a circuit board; and
the chip package structure according to any one of claims 1 to 10, or a chip package structure prepared according to the packaging method of a chip package structure according to any one of claims 11 to 17; wherein
the chip package structure is disposed on the circuit board.
